# EUROPÄISCHE PATENTANMELDUNG

(11) **EP 2 551 677 A1**
(43) Veröffentlichungstag der Anmeldung: **30.01.2013**
(21) Anmeldenummer: 12004719.6
(22) Anmeldetag: 23.06.2012
(51) Int. Cl.: G01R 11/04, H01R 9/24

(54) **Adapterbaugruppe**

(30) Priorität: 29.07.2011 DE 102011108950; 16.05.2012 DE 102012009725
(71) Anmelder: ABB AG, 68309 Mannheim (DE)
(72) Erfinder: Wieland, Ralf, 69429 Waldbrunn (DE); Eppe, Klaus-Peter, 69429 Waldbrunn (DE); Siedelhofer, Bernd, 69121 Heidelberg (DE)

(57) **Zusammenfassung**

Die Erfindung betrifft eine Adapterbaugruppe (1) zur Anbringung an einer ein Zählerkreuz aufweisenden Zählerplatzinstallation, mit einer Befestigungs- und Kontaktiereinrichtung (2) für einen elektronischen Stromzähler, wobei die Befestigungs- und Kontaktiereinrichtung (2) eine Zählertragplatte (9) aufweist mit Öffnungsschlitzen (10), in die von dem Stromzähler vorstehende Anschlusskontaktelemente einführbar und mit hinter der Zählertragplatte angeordneten Anschlussleiterstücken (11) verbindbar sind, mit einer Anschlussleiste (3) für den Anschluss von Stromkabeln, wobei die Anschlussleiste wenigstens eine einem Zuführungs-Anschlussleiterstück zugeordnete Stromzuführungskontaktstelle (4) für ungezählten Strom und wenigstens eine einem Abführungs-Anschlussleiterstück (11) zugeordnete Stromabführungskontaktstelle (5) für gezählten Strom hat, und wobei für die Anschlussleiste (3) eine plombierbare Abdeckung (6) für die Stromzuführungskontaktstelle (4) und die Stromabführungskontaktstelle (5) vorgesehen ist. Die Anschlussleiste (3) hat eine Zusatzklemmstelle (7) für den Anschluss gezählten Stroms führender Kabel, und die Abdeckung (6) hat eine Zugangsöffnung (8), die den Zugang an die Zusatzklemmstelle (7) für einen Anschlussleiter freigibt.

## Beschreibung

Die Erfindung betrifft eine Adapterbaugruppe zur Anbringung an einer ein Zählerkreuz aufweisenden Zählerplatzinstallation, mit einer Befestigungs- und Kontaktiereinrichtung für einen elektronischen Stromzähler, wobei die Befestigungs- und Kontaktiereinrichtung eine Zählertragplatte aufweist mit Öffnungsschlitzen, in die von dem Stromzähler vorstehende Anschlusskontaktelemente einführbar und mit hinter der Zählertragplatte angeordneten Anschlussleiterstücken verbindbar sind, mit einer Anschlussleiste für den Anschluss von Stromkabeln, wobei die Anschlussleiste wenigstens eine einem Zuführungs-Anschlussleiterstück zugeordnete Stromzuführungskontaktstelle für ungezählten Strom und wenigstens eine einem Abführungs-Anschlussleiterstück zugeordnete Stromabführungskontaktstelle für gezählten Strom hat, und wobei für die Anschlussleiste eine plombierbare Abdeckung für die Stromzuführungskontaktstelle und die Stromabführungskontaktstelle vorgesehen ist, gemäß dem Oberbegriff des Anspruchs 1.

Eine Adapterbaugruppe für einen elektronischen Stromzähler ist beispielsweise aus der DE 103 44 736 A1 bekannt. Sie kann an Stelle eines herkömmlichen elektromechanischen Stromzählers am Zählerkreuz einer Zählerplatzinstallation befestigt werden. Die Adapterbaugruppe ist im Wesentlichen kastenartig ausgebildet. Sie umfasst eine Befestigungs- und Kontaktiereinrichtung zur Aufnahme eines elektronischen Stromzählers. Die Befestigungs- und Kontaktiereinrichtung umfasst eine Zählertragplatte mit Öffnungsschlitzen, in die von dem Stromzähler vorstehende Anschlusskontaktelemente eingeführt werden können. Hinter der Zählertragplatte sind Anschlussleiterstücke angeordnet, die beim Einsetzen des Stromzählers mit den Anschlusskontaktelementen des Stromzählers verbunden werden und die die elektrische Verbindung zwischen den Anschlusskontaktstücken des Stromzählers und den Stromzuführungs- bzw. Stromabführungskontaktstellen an der Anschlussleiste herstellen. Die Adapterbaugruppe gemäß der DE 103 44 736 A1 hat je ein Paar Stromzuführungs- bzw. Stromabführungskontaktstellen für jede Phase und für den Nulleiter. Die Anschlussleiterstücke jeder Phase sind hinter der Zählertragplatte mit feststehenden Kontaktstücken und einem Überbrückungselement verbunden. Die Anordnung ist so gestaltet, dass, wenn der Stromzähler von der Zählertragplatte abgenommen wird, die Überbrückungselemente die feststehenden Kontaktstücke jeder Phase überbrücken, so dass bei einem Zählerwechsel keine Unterbrechung des Stromflusses von dem Zählerplatz zu dem nachgeordneten Verbraucherstromkreis hin stattfindet. Wenn der Zähler in die Schlitze eingesetzt und in seine Betriebsposition gebracht wird, dann werden die Überbrückungselemente verschoben, und der Strom jeder Phase fließt von der Stromzuführungskontaktstelle über den Zähler zu der Stromabführungskontaktstelle, wo er als gezählter Strom dem nachgeordneten Verbraucherstromkreis zufließt.

An der Anschlussleiste sind die Stromzuführungs- bzw. Stromabführungskontaktstellen in der Regel nebeneinander liegend angeordnet. Der Anlagenkunde soll im Betrieb der Verbraucheranlage keinen Zugang zu den den ungezählten Strom führenden Stromzuführungsklemmen bekommen. Die EP 2 267 462 A1 zeigt daher einen Adapterbaugruppe, bei der eine den Zugang zu der Anschlussleiste verhindernde Abdeckung der Anschlussleiste vorgesehen ist, die durch den Stromzähler selbst festgehalten wird und daher durch Plombieren des Stromzählers gesichert ist, das heißt, der auf der Zählertragplatte aufsitzende und dort plombierte Stromzähler verhindert die Entnahme der Abdeckung und damit den Zugang zum ungezählten Strom.

In modernen Verbraucheranlagen befinden sich im Bereich der Zählerplatzinstallation noch Zusatzgeräte, wie beispielsweise Kommunikations- oder Tarifsteuergeräte, die mit gezähltem Strom versorgt werden sollen. Hierfür besitzt die Adapterbaugruppe gemäß der EP 2 267 462 A1 eine zusätzliche obere Anschlussleiste mit weiteren Anschlussklemmen für gezählten Strom, insgesamt also zwei unterschiedliche Anschlussleiten. Auch die obere Anschlussleiste kann mit einer separaten Abdeckung abgedeckt werden. Der Aufbau einer solchen Adapterbaugruppe ist jedoch wegen der beiden unterschiedlichen Anschlussleisten aufwändig.

Es ist daher die Aufgabe der vorliegenden Erfindung, eine Adapterbaugruppe zu schaffen, bei der Zusatzgeräte mit gezähltem Strom versorgt werden können, wobei der Aufbau der Adapterbaugruppevereinfacht ist, und wobei die Plombierung des Anschlussleisten-Bereichs des ungezählten und des nicht für die Versorgung der Zusatzgeräte benötigten gezählten Stroms unberührt bleibt.

Die Aufgabe wird gelöst durch eine Adapterbaugruppe mit den Merkmalen des Anspruchs 1.

Erfindungsgemäß also hat die Anschlussleiste eine Zusatzklemmstelle für den Anschluss gezählten Stroms führender Kabel, und die Abdeckung hat eine Zugangsöffnung, die den Zugang an die Zusatzklemmstelle für einen Anschlussleiter freigibt.

Die Versorgung des Zusatzgerätes erfolgt also über eine Zusatzklemmstelle an der einzigen Anschlussleiste, wodurch der Aufbau vereinfacht ist, und die Zusatzklemme kann mit einem das Zusatzgerät versorgenden Stromkabel versehen werden, ohne dass die plombierte Abdeckung des ungezählten und des nicht für die Versorgung der Zusatzgeräte benötigten gezählten Stroms entfernt werden muss.

Eine erfindungsgemäße Zusatzklemmstelle mit der entsprechend zugeordneten Zugangsöffnung in der Abdeckung kann dabei für eine Phase, für zwei Phasen oder für alle drei Phasen, jeweils ergänzend auch zusätzlich noch für den Neutralleiter vorgesehen sein.

In einer vorteilhaften Ausführungsform der Erfindung ist die Zusatzklemmstelle bezogen auf die Längsmitte der Anschlussleiste in Richtung auf die Zählertragplatte hin versetzt angeordnet. Sie kommt damit in etwa schräg oberhalb der ihr zugeordneten Stromabführungskontaktstelle zu liegen. Damit ist eine raumsparende Anordnung gegeben.

In einer vorteilhaften Ausführungsform der Erfindung umfasst die Stromabführungskontaktstelle ein an dem Abführungs-Anschlussleiterstück ausgebildetes Abführungs-Klemmstück, an dem ein gezählten Strom führendes Kabel anklemmbar ist, und die Zusatzklemmstelle umfasst ein an dem Abführungs-Klemmstück ausgebildetes Zusatzklemmstück, an dem ein zusätzliches, gezählten Strom führendes Kabel anklemmbar ist.

Zum Anklemmen des Stromkabels kann eine an sich bekannte Schraubenklemm-Technik benutzt werden. Die Klemmstelle für das den gezählten Strom abführende Kabel befindet sich an dem Abführungs-Klemmstück. Dort wird beispielsweise ein Klemmrahmen mittels einer Klemmschraube gegen das Abführungs-Klemmstück gedrückt, und ein in den Zwischenraum zwischen dem Klemmrahmen und dem Abführ-Klemmstück eingeführtes Kabel wird dabei gegen das Abführ-Klemmstück gepresst. Die Zusatzklemmstelle befindet sich gewissermaßen als Verlängerung des Abführungs-Klemmstücks an demselben Abführungs-Leiterstück. Aufgrund des Versatzes der Zusatzklemmstelle mit der Abführungs-Klemmstelle kommt das an die Zusatzklemmstelle angeklemmte Kabel oberhalb des an die Abführungs-Klemmstelle eingeführte Kabel zu liegen. Die Klemmschraube der Abführkontaktstelle ist durch die Abdeckung verdeckt, bei aufgesetzter und plombierter Abdeckung kann daher nicht auf die Abführ-Kontaktstelle zugegriffen werden. Nur die Zusatz-Kontaktstelle, und hier auch die Klemmschraube der Zusatz-Klemmstelle, ist aufgrund der Zugangsöffnung in der Abdeckung für das Anklemmen eines Zusatzleiters zugänglich.

In einer vorteilhaften Ausführungsform der Erfindung sind das Abführungs-Klemmstück und das Zusatzklemmstück jeweils als plattenförmige Stromschienen ausgebildet, und das Zusatz-Klemmstück ist bezogen auf die Längserstreckungsebene des Abführungs-Klemmstücks versetzt in Richtung auf die Zählertragplatte hin angeordnet, und das Abführungs-Klemmstück und das Zusatzklemmstück sind durch eine Verbindungs-Stromschiene verbunden. Auf diese Weise befindet sich die Zusatzklemmstelle gewissermaßen als Verlängerung des Abführungs-Klemmstücks an demselben Abführungs-Leiterstück, schräg oberhalb der Abführungsklemmstelle.

In einer vorteilhaften Ausführungsform der Erfindung ist das Abführungs-Anschlussleiterstück zusammen mit dem Abführungs-Klemmstück, der Verbindungs-Stromschiene und dem Zusatzklemmstück als Stanzbiegeteil aus einem Stück Leiterblech hergestellt. Dies ist eine besonders einfache und kostengünstigen Herstellungsmethode.

In einer vorteilhaften Ausführungsform der Erfindung ist die Abdeckung mit wenigstens einer mittels eines Plombierdrahtes plombierbaren Schraube an der Befestigungs- und Kontaktiereinrichtung gehalten.

In einer vorteilhaften Ausführungsform der Erfindung ist die Zugangsöffnung rechteckförmig ausgebildet, wobei an der der Zählertragplatte zuweisenden Schmalseite der Zugang zu der Zusatzklemmstelle vorgesehen ist, und an der gegenüberliegenden Schmalseite ist ein Einführkanal für den an die Zusatzklemmstelle anzuklemmenden Anschlussleiter vorgesehen. Die Klemmschraube der Zusatzklemmstelle ist dabei von oben, von der Breitseite der Abdeckung her, zugänglich. Die Einführöffnung für den an die Zusatzklemmstelle einführbaren Leiter ist dagegen aus einer senkrecht dazu versetzten Richtung zugänglich, von der unteren Schmalseite der Abdeckung her. Die Zugangsöffnung ist daher mindestens so lang, dass ein Anschlussleiter von der Einführöffnung her durch die Abdeckung hindurch an die Zusatzklemmstelle eingesetzt werden kann, aber sie ist so schmal, dass zwar die Klemmschraube der Zusatzklemme für ein Werkzeug, beispielsweise einen Schraubendreher, zugänglich ist, nicht aber die seitlich daneben liegenden Bereiche der Anschlussleiste.

In einer vorteilhaften Ausführungsform der Erfindung ist in der Zählertragplatte eine Einrichtung zur Halterung einer Datenschnittstelleneinrichtung und eines Schnittstellenkabels vorgesehen. Dies kann beispielsweise ein in Längserstreckungsrichtung der Zählertragplatte, an deren Rand verlaufender, Schlitz sein, der in einer quaderförmigen Ausnehmung mündet, in die beispielsweise ein optischer Sensor für die optischen Datenübertragung zwischen dem aufgesetzten Stromzähler und der Adapterbaugruppe eingesetzt ist.

Anhand der Zeichnungen, in denen ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:
- Figur 1: eine erfindungsgemäße Adapterbaugruppe,
- Figur 2: eine Ansicht auf die Anschlussleiste einer erfindungsgemäßen Adapterbaugruppe,
- Figur 3: eine Ansicht auf die Anschlussleiste einer erfindungsgemäßen Adapterbaugruppe mit geöffnetem Anschlussleistenraum,
- Figur 4: eine Stromschiene der Befestigungs- und Kontaktiereinrichtung, mit daran ausgebildeter Stromabführungskontaktstelle und Zusatzkontaktstelle, sowie
- Figur 5: eine Stromschiene nach Figur 4, mit entfernten Klemmkörpern.

In den Figuren werden gleiche oder gleichwirkende Bauteile oder Elemente mit denselben Bezugszeichen bezeichnet.

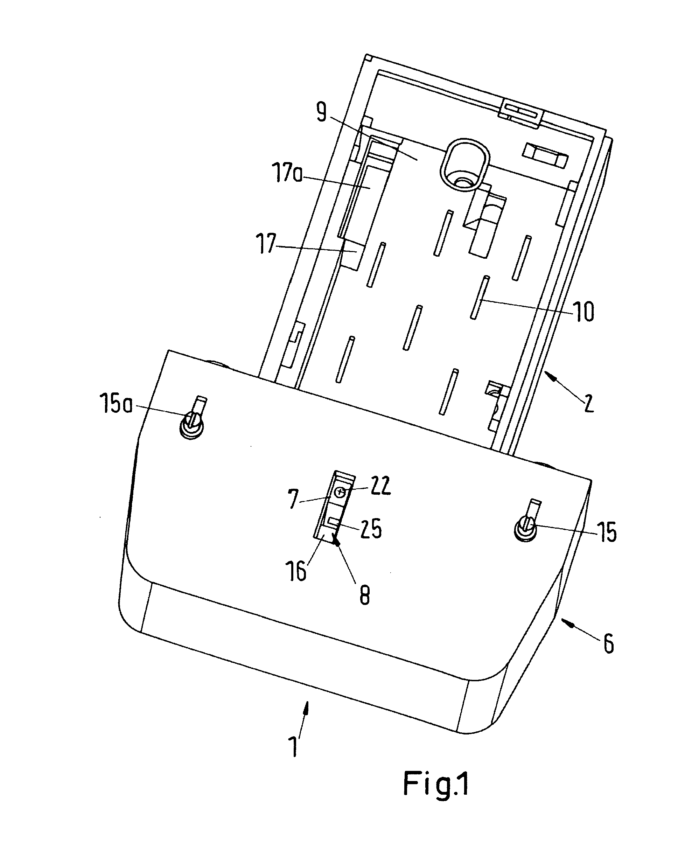

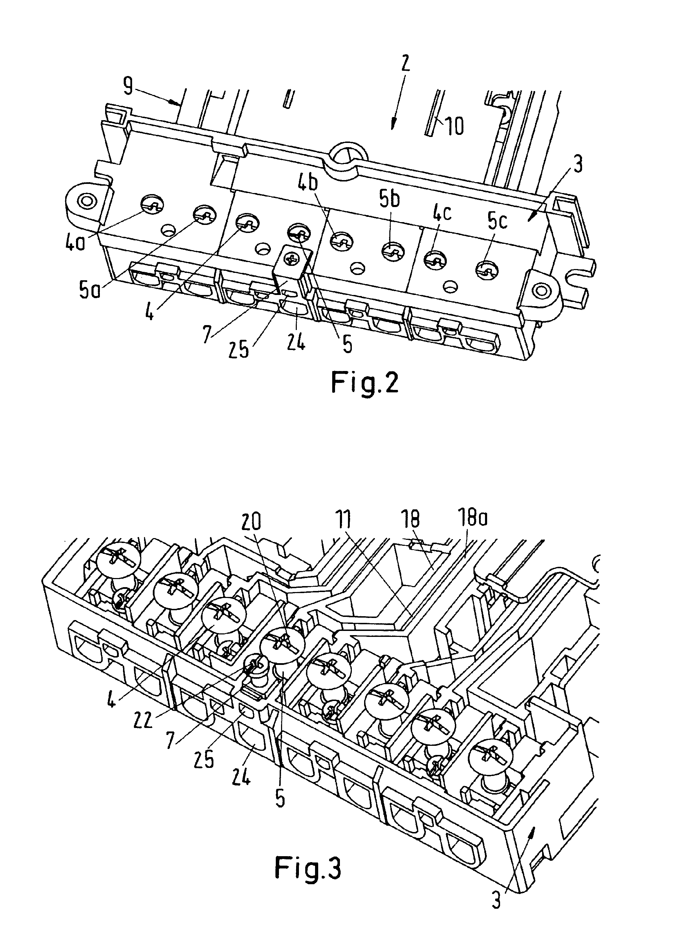

Figur 1 zeigt eine Adapterbaugruppe 1 zur Anbringung an einer ein Zählerkreuz aufweisenden Zählerplatzinstallation, mit einer Befestigungs- und Kontaktiereinrichtung 2 für einen elektronischen Stromzähler. Die Befestigungs- und Kontaktiereinrichtung 2 weist eine Zählertragplatte 9 auf mit Öffnungsschlitzen 10, in die von dem Stromzähler vorstehende Anschlusskontaktelemente einführbar und mit hinter der Zählertragplatte angeordneten Anschlussleiterstücken 11 (siehe hierzu Figur 3) verbindbar sind.

Unten an der Befestigungs- und Kontaktiereinrichtung 2 befindet sich eine Anschlussleiste 3 (siehe Figur 2 und 3) für den Anschluss von Stromkabeln. Die Anschlussleiste 3 hat vier jeweils einem Zuführungs-Anschlussleiterstück zugeordnete Stromzuführungskontaktstellen 4, 4a, 4b, 4c für ungezählten Strom und vier jeweils einem Abführungs-Anschlussleiterstück 11 zugeordnete Stromabführungskontaktstellen 5, 5a, 5b, 5c für gezählten Strom. Drei der Stromzuführungskontaktstellen 4, 4a, 4b und Stromabführungskontaktstellen 5, 5a, 5b sind den drei Phasen L1, L2, L3 zugeordnet. Das vierte Paar aus Stromzuführungskontaktstelle 4c mit Stromabführungskontaktstelle 5c ist dem Neutralleiter N zugeordnet.

Die Stromzuführungskontaktstellen 4, 4a, 4b, 4c und die Stromabführungskontaktstellen 5, 5a, 5b, 5c sind von außen durch in der Gehäusewand gebildete Einführöffnungen 24 zugänglich. Der Bereich der Stromzuführungskontaktstellen 4, 4a, 4b, 4c und die Stromabführungskontaktstellen 5, 5a, 5b, 5c ist mittels einer Deckplatte abgedeckt, in Figur 3 ist diese Deckplatte entfernt.

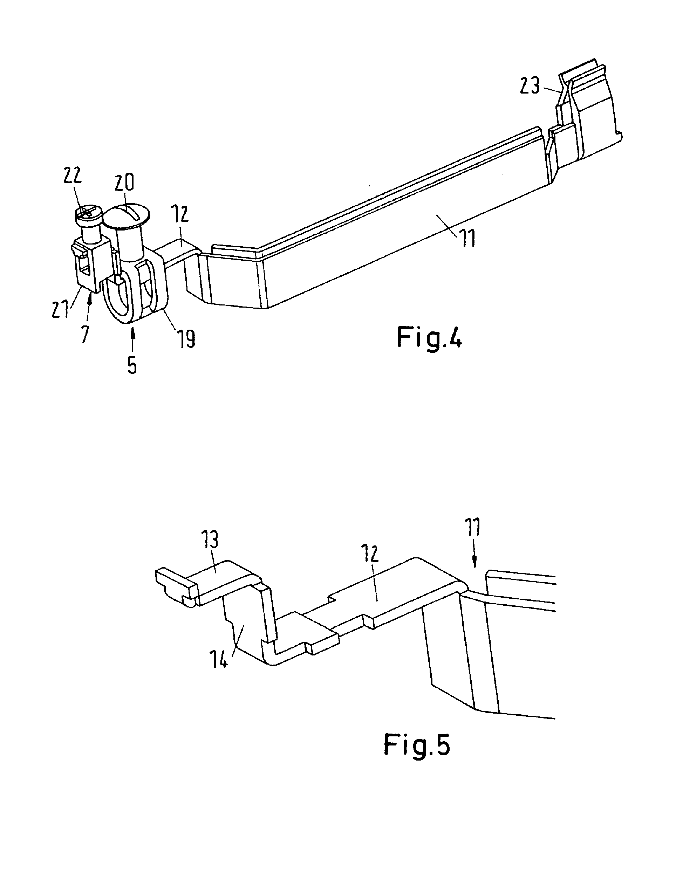

Das der Stromabführungskontaktstelle 5 zugeordnete Anschlussleiterstück wird hier auch als Abführungs-Anschlussleiterstück 11 bezeichnet und ist im Einzelnen in den Figuren 4 und 5 dargestellt. In Figur 3 sieht man, dass das Abführungs-Anschlussleiterstück 11 in der Befestigungs- und Kontaktiereinrichtung 3 in einer stegförmige Seitenwände 18, 18a aufweisenden Haltevorrichtung gehalten ist.

In der Ansicht der Figur 1 ist die Anschlussleiste mit einer Abdeckung 6 bedeckt. Diese deckt die Stromzuführungskontaktstellen 4, 4a, 4b, 4c und die Stromabführungskontaktstellen 5, 5a, 5b, 5c ab, so dass diese dem Zugang durch eine nicht dazu autorisierte Person nicht zugänglich sind. Die Abdeckung 6 ist mit zwei Schrauben 15, 15a an der Befestigungs- und Kontaktiereinrichtung 2 befestigt. Die Schrauben 15, 15a können mit einem Plombierdraht plombiert werden, so dass damit die Abdeckung 6 plombierbar ist.

In der Zählertragplatte 9 ist ein Schlitz 17 zur Halterung eines Schnittstellenkabels und eine quaderförmige Ausnehmung 17a zur Aufnahme einer Datenschnittstelleneinrichtung vorgesehen.

Wie die Figuren 2 und 3 zeigen, hat die Anschlussleiste 3 eine Zusatzklemmstelle 7 für den Anschluss gezählten Stroms führender Kabel. Die Abdeckung 6 hat eine Zugangsöffnung 8, die den Zugang an die Zusatzklemmstelle 7 für einen Anschlussleiter freigibt, auch wenn die Abdeckung 6 plombiert angebracht ist und die Stromzuführungskontaktstellen 4, 4a, 4b, 4c und die Stromabführungskontaktstellen 5, 5a, 5b, 5c abdeckt.

Die Zusatzklemmstelle 7 ist bezogen auf die Längsmitte der Anschlussleiste 3 in Richtung auf die Zählertragplatte 9 hin versetzt angeordnet. Sie kommt damit in etwa schräg oberhalb der ihr zugeordneten Stromabführungskontaktstelle 5 zu liegen. Damit ist eine raumsparende Anordnung gegeben.

Die Zugangsöffnung 8 in der Abdeckung 6 ist rechteckförmig ausgebildet, wobei an der der Zählertragplatte 9 zuweisenden Schmalseite der Zugang zu der Zusatzklemmstelle 7 vorgesehen ist, und an der gegenüberliegenden Schmalseite ist ein Einführkanal für den an die Zusatzklemmstelle anzuklemmenden Anschlussleiter vorgesehen. Die Zusatz-Klemmschraube 22 der Zusatzklemmstelle 7 ist dabei von oben, von der Breitseite der Abdeckung 6 her, zugänglich. Die Zusatz-Einführöffnung 25 für den an die Zusatzklemmstelle 7 einführbaren Leiter ist dagegen aus einer senkrecht dazu versetzten Richtung zugänglich, von der unteren Schmalseite der Abdeckung 6 her. Die Zugangsöffnung 8 ist daher mindestens so lang, dass ein Anschlussleiter von der Zusatz-Einführöffnung 25 her durch die Abdeckung 6 hindurch an die Zusatzklemmstelle 7 eingesetzt werden kann, aber sie ist so schmal, dass zwar die Zusatz-Klemmschraube 22 der Zusatzklemme 7 für ein Werkzeug, beispielsweise einen Schraubendreher, zugänglich ist, nicht aber die seitlich daneben liegenden Bereiche der Anschlussleiste 3.

Die Stromabführungskontaktstelle 5 umfasst ein an dem Abführungs-Anschlussleiterstück 11 ausgebildetes Abführungs-Klemmstück 12, an dem ein gezählten Strom führendes Kabel anklemmbar ist. Die Zusatzklemmstelle 7 umfasst ein an dem Abführungs-Klemmstück 12 ausgebildetes Zusatzklemmstück 13, an dem ein zusätzliches, gezählten Strom führendes Kabel anklemmbar ist.

Zum Anklemmen des Stromkabels kann eine an sich bekannte Schraubenklemm-Technik benutzt werden. Die Klemmstelle für das den gezählten Strom abführende Kabel befindet sich an dem Abführungs-Klemmstück 12. Dort wird beispielsweise ein Klemmrahmen 19 mittels einer Klemmschraube 20 gegen das Abführungs-Klemmstück 12 gedrückt, und ein in den Zwischenraum zwischen dem Klemmrahmen 19 und dem Abführ-Klemmstück 12 eingeführtes Kabel wird dabei gegen das Abführ-Klemmstück 12 gepresst.

Entsprechend wird ein Zusatz-Klemmrahmen 21 mittels einer Zusatz-Klemmschraube 22 gegen das Zusatz-Klemmstück 13 gedrückt, und ein in den Zwischenraum zwischen dem Zusatz-Klemmrahmen 21 und dem Zusatz-Klemmstück 13 eingeführtes Kabel wird dabei gegen das Zusatz-Klemmstück 13 gepresst.

Die Zusatzklemmstelle 7 befindet sich gewissermaßen als Verlängerung des Abführungs-Klemmstücks 12 an demselben Abführungs-Leiterstück 11. Aufgrund des Versatzes der Zusatzklemmstelle 7 mit der Abführungs-Klemmstelle 5 kommt das an die Zusatzklemmstelle 7 angeklemmte Kabel oberhalb des an die Abführungs-Klemmstelle 5 eingeführte Kabel zu liegen.

Die Klemmschraube 20 der Abführkontaktstelle 5 ist in Figur 1 durch die Abdeckung 6 verdeckt, bei aufgesetzter und plombierter Abdeckung kann daher nicht auf die Abführ-Kontaktstelle 5 zugegriffen werden. Nur die Zusatz-Kontaktstelle 7, und hier auch die Zusatz-Klemmschraube 22 der Zusatz-Klemmstelle 7, ist aufgrund der Zugangsöffnung 8 in der Abdeckung 6 für das Anklemmen eines Zusatzleiters zugänglich.

Wie die Figuren 4 und 5 zeigen sind das Abführungs-Klemmstück 12 und das Zusatzklemmstück 13 jeweils als plattenförmige Stromschienen ausgebildet, und das ZusatzKlemmstück 13 ist bezogen auf die Längserstreckungsebene des Abführungs-Klemmstücks 12 versetzt in Richtung auf die Zählertragplatte 9 hin angeordnet, und das Abführungs-Klemmstück 12 und das Zusatzklemmstück 13 sind durch eine Verbindungs-Stromschiene 14 verbunden. Das Abführungs-Anschlussleiterstück 11 ist hierbei zusammen mit dem Abführungs-Klemmstück 12, der Verbindungs-Stromschiene 14 und dem Zusatzklemmstück 13 als Stanzbiegeteil aus einem Stück Leiterblech hergestellt. An dem den Klemmstellen gegenüberliegenden Ende des Abführungs-Leiterstücks 11 ist eine feste Kontaktstelle 23 ausgebildet in Form einer U-förmigen Aufnahme für ein plattenförmig ausgebildetes, nicht dargestelltes, Überbrückungselement, dessen Funktion in der DE 103 44 736 beschrieben ist.

Für den Fachmann ist ohne weiteres ersichtlich, dass die Erfindung nicht auf die Einzelheiten der vorstehenden veranschaulichenden Ausführungsform beschränkt ist, und dass die vorliegende Erfindung in anderen speziellen Formen ausgeführt werden kann, ohne dass von wesentlichen Attributen derselben abgewichen wird, und es ist daher erwünscht, dass die vorliegenden Ausführungsformen in jeder Hinsicht als veranschaulichend und nichtbeschrankend betrachtet werden.

### Bezugszeichenliste

| | |
|---|---|
| 1 | Adapterbaugruppe |
| 2 | Befestigungs- und Kontaktiereinrichtung |
| 3 | Anschlussleiste |
| 4, 4a, 4b, 4c | Stromzuführungskontaktstelle |
| 5, 5a, 5b, 5c | Stromabführungskontaktstelle |
| 6 | Plombierbare Abdeckung |
| 7 | Zusatzklemmstelle |
| 8 | Zugangsöffnung |
| 9 | Zählertragplatte |
| 10 | Öffnungsschlitz |
| 11 | Abführungs-Anschlussleiterstück |
| 12 | Abführungs-Klemmstück |
| 13 | Zusatzklemmstück |
| 14 | Verbindungsstromschiene |
| 15, 15a | Schraube |
| 16 | Einführkanal |
| 17 | Schlitz |
| 17a | Ausnehmung |
| 18 | Seitenwand |
| 18a | Seitenwand |
| 19 | Klemmrahmen |
| 20 | Klemmschraube |
| 21 | Zusatz-Klemmrahmen |
| 22 | Zusatz-Klemmschraube |
| 23 | Feste Kontaktstelle |
| 24 | Einführöffnung |
| 25 | Zusatz-Einführöffnung |
| | |

## Patentansprüche

1. Adapterbaugruppe (1) zur Anbringung an einer ein Zählerkreuz aufweisenden Zählerplatzinstallation, mit einer Befestigungs- und Kontaktiereinrichtung (2) für einen elektronischen Stromzähler, wobei die Befestigungs- und Kontaktiereinrichtung (2) eine Zählertragplatte (9) aufweist mit Öffnungsschlitzen (10) , in die von dem Stromzähler vorstehende Anschlusskontaktelemente einführbar und mit hinter der Zählertragplatte angeordneten Anschlussleiterstücken (11) verbindbar sind, mit einer Anschlussleiste (3) für den Anschluss von Stromkabeln, wobei die Anschlussleiste wenigstens eine einem Zuführungs-Anschlussleiterstück zugeordnete Stromzuführungskontaktstelle (4) für ungezählten Strom und wenigstens eine einem Abführungs-Anschlussleiterstück (11) zugeordnete Stromabführungskontaktstelle (5) für gezählten Strom hat, und wobei für die Anschlussleiste (3) eine plombierbare Abdeckung (6) für die Stromzuführungskontaktstelle (4) und die Stromabführungskontaktstelle (5) vorgesehen ist,
**dadurch gekennzeichnet, dass** die Anschlussleiste (3) eine Zusatzklemmstelle (7) für den Anschluss gezählten Stroms führender Kabel hat, und dass die Abdeckung (6) eine Zugangsöffnung (8) hat, die den Zugang an die Zusatzklemmstelle (7) für einen Anschlussleiter freigibt.

2. Adapterbaugruppe (1) nach Anspruch 1, **dadurch gekennzeichnet, dass** die Zusatzklemmstelle (7) bezogen auf die Längsmitte der Anschlussleiste (3) in Richtung auf die Zählertragplatte (9) hin versetzt angeordnet ist.

3. Adapterbaugruppe (1) nach Anspruch 1, **dadurch gekennzeichnet, dass** die Stromabführungskontaktstelle (5) ein an dem Abführungs-Anschlussleiterstück (11) ausgebildetes Abführungs-Klemmstück (12) umfasst, an dem ein gezählten Strom führendes Kabel anklemmbar ist, und dass die Zusatzklemmstelle (7) ein an dem Abführungs-Klemmstück (12) ausgebildetes Zusatzklemmstück (13) umfasst, an dem ein zusätzliches, gezählten Strom führendes Kabel anklemmbar ist.

4. Adapterbaugruppe (1) nach Anspruch 3, **dadurch gekennzeichnet, dass** das Abführungs-Klemmstück (12) und das Zusatzklemmstück (13) jeweils als plattenförmige Stromschienen ausgebildet sind, dass das Zusatz-Klemmstück (13) bezogen auf die Längserstreckungsebene des Abführungs-Klemmstücks (12) versetzt in Richtung auf die Zählertragplatte (9) hin angeordnet ist, und dass das Abführungs-Klemmstück (12) und das Zusatzklemmstück (13) durch eine Verbindungs-Stromschiene (14) verbunden sind.

5. Adapterbaugruppe (1) nach Anspruch 4, **dadurch gekennzeichnet, dass** das Abführungs-Anschlussleiterstück (11) zusammen mit dem Abführungs-Klemmstück (12), der Verbindungs-Stromschiene (14) und dem Zusatzklemmstück (13) als Stanzbiegeteil aus einem Stück Leiterblech hergestellt ist.

6. Adapterbaugruppe (1) nach Anspruch 1, **dadurch gekennzeichnet, dass** die Abdeckung (6) mit wenigstens einer mittels eines Plombierdrahtes plombierbaren Schraube(15) an der Befestigungs- und Kontaktiereinrichtung (2) gehalten ist.

7. Adapterbaugruppe (1) nach Anspruch 1, **dadurch gekennzeichnet, dass** die Zugangsöffnung (8) rechteckförmig ausgebildet ist, wobei an der der Zählertragplatte zuweisenden Schmalseite der Zugang zu der Zusatzklemmstelle vorgesehen ist, und an der gegenüberliegenden Schmalseite ein Einführkanal (16) für den an die Zusatzklemmstelle anzuklemmenden Anschlussleiter vorgesehen ist.

8. Adapterbaugruppe (1) nach Anspruch 1, **dadurch gekennzeichnet, dass** in der Zählertragplatte (9) eine Einrichtung (17) zur Halterung einer Datenschnittstelleneinrichtung und eines Schnittstellenkabels vorgesehen ist.
